# EUROPEAN PATENT APPLICATION

(11) **EP 4 498 101 A1**
(43) Date of publication of application: **29.01.2025**
(21) Application number: 23315293.3
(22) Date of filing: 24.07.2023
(51) Int. Cl.: G01R 29/08, G01R 27/02

(54) **FLYING DRONE FOR CHECKING LIGHTNING EQUIPMENT AND ASSOCIATED METHOD**

(71) Applicant: TotalEnergies OneTech, 92400 Courbevoie (FR)
(72) Inventor: Raboin, Jean-Christophe, 92400 COURBEVOIE (FR); Clement, Guillaume, 92400 COURBEVOIE (FR)
(74) Representative: Innovincia

(57) **Abstract**

The present invention refers to a flying drone (1) for checking lightning protection equipment (11, 23) comprising:
- a femtosecond laser (31),
- a probe (27),
- an electrical conductor (33) having a first end (33a) linked to the probe (27) and a second end (33b) arranged in the radiance of the femtosecond laser (31),
- a measuring unit (35) configured for measuring an electrical resistance along the electrical conductor (33),
- a processing unit (15),
wherein the processing unit (15) is configured:
- for controlling the flying drone (1) to set the probe (27) in contact with a lightning receptor (11) of a lightning protection equipment (11, 23),
- for controlling the femtosecond laser (31) to transmit a femtosecond pulse directed towards the ground while the probe (27) is in contact with the lightning receptor (11) and,
- for controlling the measuring unit (35) to measure an electrical resistance along the electrical conductor (33) during the transmission of the femtosecond pulse towards the ground.

## Description

### Background of the invention

The field of the present invention refers to the inspection of lightning protection equipment in particular of lightning protection equipment of wind turbine blades, for example in offshore wind farms.

Lightnings may cause severe damages to constructions such as wind turbines. To prevent such damages, large constructions are usually equipped with lightning protection devices configured to forward the energy of the lightning towards the ground.

In the case of wind turbines, the lightning protection devices may be made of lightning receptors made of a conductive material such as copper, which are distributed on the blade, the said lightning receptors being linked to the ground through a conductive pass, for example through a cable or through carbon fiber elements or a mix of these elements.

However, due to the mechanical constraints undergone by the blades under the effects of the wind or the waves or due to a former lightning, the lightning protection device may be inoperable, for example because of a discontinuity of the conductive pass from the lightning receptor to the ground. It is therefore necessary to regularly check the correct functioning of the lightning protection device.

To this end, a known solution to test the different lighting receptors is to use a drone linked to the ground by a cable and to measure the resistance between the lightning receptors and the ground by flying the drone from one receptor to the other. However, such solution may be particularly difficult to set up notably in offshore wind farm due to the management of the cable linked to the drone in particular in windy conditions.

It appears therefore necessary to find a solution to ease the checking of the lightning protection devices made by drones on large constructions such as wind turbines.

The present invention aims therefore at providing such a solution.

### Summary of the invention

The present invention refers to a flying drone for checking lightning protection equipment comprising:
- a femtosecond laser,
- a probe,
- an electrical conductor having a first end linked to the probe and a second end arranged in the radiance of the femtosecond laser,
- a measuring unit configured for measuring an electrical resistance along the electrical conductor,
- a processing unit,
wherein the processing unit is configured:
- for controlling the flying drone to set the probe in contact with a lightning receptor of a lightning protection equipment,
- for controlling the femtosecond laser to transmit a femtosecond pulse directed towards the ground while the probe is in contact with the lightning receptor and,
- for controlling the measuring unit to measure an electrical resistance along the electrical conductor during the transmission of the femtosecond pulse towards the ground.

According to another aspect of the invention, the processing unit is also configured for comparing the measured electrical resistance with a predetermined value and for emitting an alarm if the measured value is higher than the predetermined value.

According to another aspect of the invention, the duration of the transmitted pulse is chosen so that the energy of the pulse produces an ionization of at least one gaseous species of the air and so that a plasma is formed between the drone and the ground.

According to another aspect of the invention, the transmitted pulse has a duration comprised between ten and hundreds of femtoseconds.

According to another aspect of the invention, the wavelength of the femtosecond laser is comprised between 800nm and 1300nm, preferably from 850nm to 1200nm.

According to another aspect of the invention, the probe is located on a retractable arm of the flying drone.

According to another aspect of the invention, the drone comprises a positioning system to determine its position with respect to the lightning receptor, for example a positioning system based on a light detection and ranging "LIDAR" technology and/or an optical detector such as a camera or video recorder.

According to another aspect of the invention, the flying drone comprises a detector configured for detecting an identification label associated with a lightning receptor to locate and/or identify the lightning receptor.

According to another aspect of the invention, the identification label refers to a quick response "QR" code or a barcode and the detector refers to a camera or video recorder.

According to another aspect of the invention, the identification label refers to a radio frequency identification "RFID" label and the detector (13) refers to a RFID reader.

The present invention also refers to a method for checking lightning protection equipment comprising the following steps:
- flying a drone equipped with a probe and a femtosecond laser towards a lightning protection equipment, the probe being electrically connected to the femtosecond laser radiance by an electrical conductor,
- setting the probe in contact with a lightning receptor of a lightning protection equipment,
- transmitting, by the femtosecond laser, a femtosecond pulse directed towards the ground while the probe is in contact with the lightning receptor and,
- measuring an electrical resistance of the electrical conductor during the transmission of the femtosecond pulse.

According to another aspect of the invention, the method also comprises the following steps:
- comparing the measured electrical resistance with a predetermined value and,
- emitting an alarm if the measured value is higher than the predetermined value.

### Brief description of the drawings

[Fig.1] is a diagram of a flying drone according to the present invention;
[Fig.2] is a diagram of a wind turbine;
[Fig.3] is a diagram of the flying drone of Fig. 1 while checking the lightning protection equipment of the wind turbine of Fig.2;
[Fig.4] is a flowchart of the different steps of the method for checking a lightning protection equipment.

### Detailed description of the invention

The following achievements are examples. Although the specification refers to one or several embodiments, it does not imply that each reference refers to the same embodiment or that the features apply only to a single embodiment. Simple features of different embodiments can also be combined to provide other embodiments.

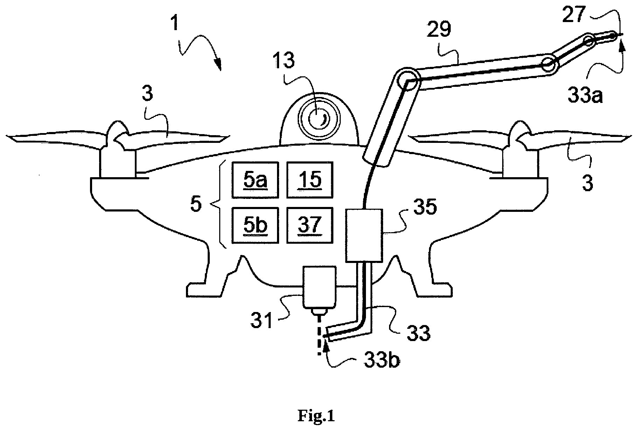

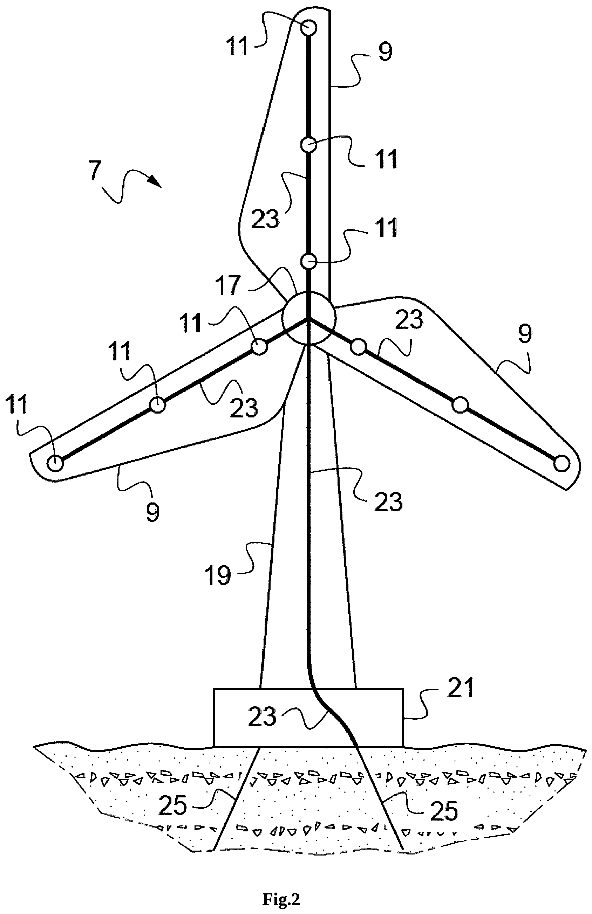

Fig.1 represents a diagram of a flying drone 1, also called unmanned aerial vehicle (UAV). The flying drone 1 may have several propellers 3, for example four propellers 3 arranged in four arms of the flying drone 1 but other configurations with a different number of propellers 3 may also be used. The flying drone 1 also comprises at least one positioning system 5 so that the flying drone 1 can fly to the equipment that has to be inspected and detect a lightning receptor 9 located on the equipment. The equipment to be inspected refers for example to a wind turbine 7 as represented in Fig.2. The wind turbine 7 may be part of an offshore wind farm comprising a plurality of wind turbines 7 that need to be inspected successively and regularly.

Thus, the flying drone 1 may comprise a first positioning system 5a such as a positioning system based on a global positioning system "GPS" technology in order to enable the flying drone 1 to fly from a docking station, which may be located on a service offshore vessel, to the targeted equipment, for example a wind turbine 7. The flying drone 1 may also comprise a second positioning system 5b such as a positioning system based on a light detection and ranging "LIDAR" technology to enable the flying drone 1 to determine its position with respect to the equipment to be inspected. Indeed, in the case of an offshore wind turbine 7, the position of the wind turbine 7 may vary depending on the waves, the wind and the sea currents in addition to the position of the blades 9 with respect to the mast 19 (even if this parameter may be controlled) so that a GPS device 5a may not enable the flying drone 1 to detect accurately its position relative to the lightning receptors 11 of the wind turbine 7. A LIDAR device 5b may then enable the flying drone 1 to detect the position of the blades 9 and therefore to determine the position of the lightning receptors 11 located on the blades 9 of the wind turbine 7 (the 3D model of the wind turbine 7 may be registered in a memory of the flying drone 1). Alternatively or additionally, the flying drone 1 may also comprise an optical detector 13 such as a camera or a video recorder associated with a processing unit 15 configured for analyzing the images taken by the optical detector 13 to detect a lightning receptor 11 on a blade 9 of the wind turbine 7.

According to an embodiment, an identification label is associated with a lightning receptor 11. The identification label may refer to a quick response "QR" code or a barcode or any other identifiable designs which can be engraved on the lightning receptor 11 or stuck next to the lightning receptor 11 (for example above the lightning receptor 11). The flying drone 1 may then be equipped with a detector such as an optical detector 13 configured to detect the identification label and therefore to locate and/or identify the associated lightning receptor 11. Alternatively, the identification label may refer to a radio frequency identification "RFID" label arranged next to the lightning receptor 11 and the flying drone 1 may be equipped with a RFID reader to detect the RFID label and therefore to locate and identify the associated lightning receptor 11. Such identification labels enable easing the location and the identification of the different lightning receptors 11 by the flying drone 1.

Fig.2 is an embodiment of a wind turbine 7 comprising lightning receptors 11 arranged along the blades 9 of the wind turbine 7. In this example, the wind turbine 7 comprises three blades 9 arranged rotatably around a hub 17 located on a mast 19. In the case of an offshore wind farm, the mast 19 may be arranged on a floating structure 21 which is moored to the sea floor, for example via moored lines 25 such as cables. A plurality of lightning receptors 11, three lightning receptors 11 in the present example, are arranged on a side of a blade 9 (lightning receptors 11 are generally arranged on both sides of the blade 9). However, a different number of lightning receptors 11 such as a single lightning receptor 11 may be arranged on a blade 9. The lightning receptors 11 may be made of a copper chip integrated in the blade 9. The copper chip has for example a diameter of a few centimeters. The different lightning receptors 11 are connected to the electrical ground (associated for example with a mooring line 25 of the floating structure 21 or the ground or the sea) via an electrical conductor 23 such as a cable linking the different lightning receptors 11 and lying through the mast 19 to the floating structure 21. The electrical conductor 23 may also be made of carbon fiber elements or a combination of cables and carbon fiber elements connected together to provide electrical conduction from the different lightning receptors 11 to the electrical ground. Within the hub 17, the electrical conductor 23 may be implemented with a turning joint and brushes to ensure the electrical contact between the static part and the rotating parts of the hub 17.

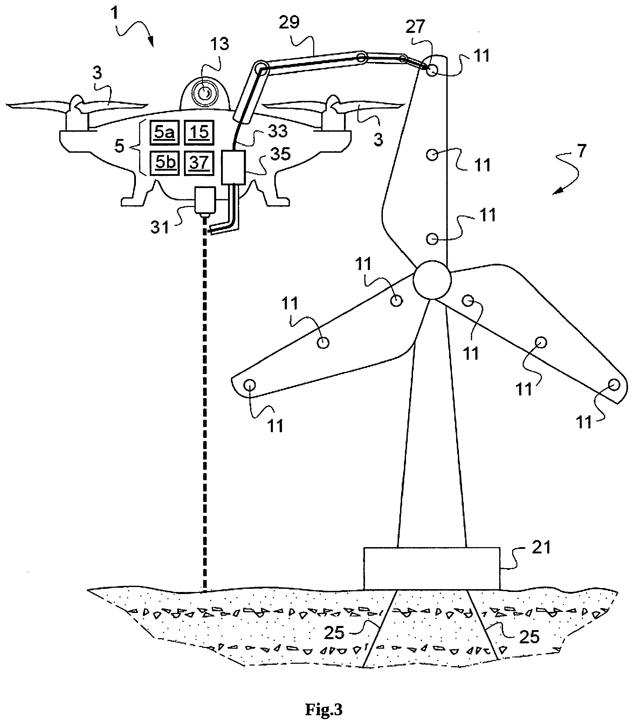

The flying drone 1 is also equipped with a probe 27 configured to be brought into contact with a lightning receptor 11 as represented in Fig.3. The probe 27 may be arranged on a retractable arm 29 such as an articulated and/or telescopic arm 29. Alternatively, the probe 27 may be stationary with respect to the flying drone 1.

The flying drone 1 is also equipped with a femtosecond laser 31 which is arranged on the flying drone 1 for transmitting femtosecond pulses directed towards the ground. The direction of the ground refers herein to a direction towards the center of the earth but the ground may correspond to the sea or the ocean, for example in the case of an offshore wind farm.

The duration of the pulse transmitted by the femtosecond laser 31 is chosen so that the energy of the pulse produces a ionization of at least one gaseous species of the air (located between the flying drone 1 and the ground (which can be the sea or the ocean)) so that a plasma is formed between the flying drone 1 and the ground when a pulse is transmitted by the femtosecond laser 31. The duration of the pulse is for example comprised between 10 and a few hundreds of femtoseconds. The wavelength of the femtosecond laser 31 is comprised between 800nm and 1300nm, preferably from 850nm to 1200nm.

The flying drone 1 is also equipped with an electrical conductor 33 having a first end 33a linked to the probe 27 and a second end 33b arranged in the radiance of the femtosecond laser 31. The electrical conductor 33 is for example made of a cable such as a copper cable.

The flying drone 1 also comprises a measuring unit 35 associated with the electrical conductor 33 and configured for measuring an electrical resistance along the electrical conductor 33.

The flying drone 1 may also comprise communication means 37 for communicating with a distant device such as a distant server or its associated docking station.

The different equipments of the flying drone 1 may be connected to the processing unit 15.

The processing unit 15 is configured for controlling the flying drone 1 in order to fly the drone 1 towards a selected lightning receptor 11, for contacting the probe 27 with the selected lightning receptor 11 as represented in Fig.3, for transmitting pulses (represented by the dotted line in Fig.3) from the femtosecond laser 31 towards the ground and for measuring an electrical resistance along the electrical conductor 33 with the measuring unit 35.

The present invention also refers to a method for checking a lightning protection equipment such as the lightning protection equipment of a wind turbine 9. In the example of Fig.2, the lightning protection equipment refers to the set comprising the lightning receptors 11 and the electrical conductor 23 linking the lightning receptors 11 to the electrical ground associated with the mooring lines 25 (alternatively associated with the ground or the sea). The method is achieved with the flying drone 1, described previously.

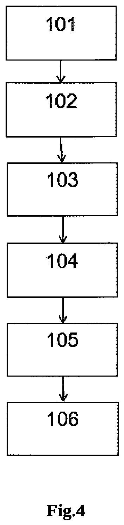

Fig.4 represents a flowchart of the different steps of the method.

The first step 101 refers to the displacement of the flying drone 1 from its docking station or from a predetermined location towards the equipment comprising the lightning protection equipment, in our example a lightning receptor 11 of a blade 9 of a wind turbine 7. Such displacement is achieved thanks to the first positioning system 5a, for example a GPS chip.

The second step 102 refers to the location of a selected lightning receptor 11. In the case of a plurality of lightning receptors 11 to check, the flying drone 1 may check the different lightning receptors 11 sequentially, one after the other. The location of the lightning receptor 11 may be achieved by a second positioning system 5b, for example a LIDAR chip and/or an optical detector 13 such as a camera. An identification label such as a QR code or a RFID label may be associated with the lightning receptor 11 and the flying drone 1 may be equipped with a detector of the said identification label such as a camera 13 or a RFID reader to ease the identification and location of the lightning receptors 11.

The third step 103 refers to the positioning of the probe 27 in contact with the selected lightning receptor 11 located in step 102. The third step 103 may comprise a sub-step of deploying the arm 29 holding the probe 27. The drone 1 then flies to set the probe 27 into contact with the selected lightning receptor 11.

The fourth step 104 refers to the transmission of femtosecond pulses by the femtosecond laser 31 towards the ground while the probe 27 is in contact with the lightning receptor 11. By ground it is referred to a direction towards the center of the earth even if the flying drone 1 is located above the sea or the ocean. The femtosecond pulses are configured for irradiating an end 33b of the electrical conductor 33 linked to the probe 27. The femtosecond laser 31 is configured so that the transmitted pulses produce an ionization of at least one gaseous species of the air. Such ionization leads to the formation of a plasma between the flying drone 1, in particular the electrical conductor 33, and the ground. Plasma lifespan resulting from a femtosecond laser pulse traditionally lasts tens to hundreds of microseconds, that is longer than the laser pulse itself. In addition, considering most of available commercial femtosecond laser devices, pulse frequency ranges from 10 to 100 MHz, one may achieve a continuous plasma string. Accordingly, cheap electrical resistance measurement, acquisition and processing means may be used in the present invention using conventional commercial parts and products.

The fifth step 105 refers to the measurement of an electrical resistance within the electrical conductor 33 by the measuring unit 35 when the femtosecond pulse is transmitted towards the ground by the femtosecond laser 31.

The sixth step 106 refers to the comparison of the measured electrical resistance with a predetermined threshold. Such comparison enables checking the correct functioning of the lightning protection equipment. Indeed, the formation of a plasma between the electrical conductor 33 and the ground leads to the formation of an electrical loop between the ground and the measuring unit 35 with one side of the loop associated with the plasma formed by the femtosecond pulse and the other side of the loop associated with the lightning protection equipment, in the present case the electrical conductor 23 linking the lightning receptor 11 to the ground within the wind turbine 7. The resistance within the electrical conductor 33 and the plasma formed by the femtosecond pulse are very small, for example a few milliohms. Thus, if a resistance higher than a predetermined threshold, for example a few ohms, is measured by the measuring unit 35, it may mean that the lightning protection equipment presents a failure such as a discontinuity of the electrical conductor 23. In such case, an alarm may be transmitted by the processing unit 15 towards a distant server to warn operators about a possible failure of the lightning protection equipment.

The different lightning receptors 11 of the wind turbine 7 may be checked successively by applying again some or all of the different steps of the method. When all the lightning receptors 11 of a wind turbine 7 are checked, the flying drone 1 may check the lightning protection equipment of another wind turbine 7 or another equipment or may go back to its docking station. If the flying drone does not comprise communication means for a distant server, the flying drone may transfer the results of the checking method to a processing unit of its docking station when back to the said docking station, such as the measured resistance, then the processing unit of the docking station may compare the received measured resistance with a predetermined threshold and may emit an alarm for the lightning receptors 11 having an associated measured resistance higher than the predetermined threshold in order to apply a maintenance procedure, for example by sending an operator on site.

Thus, the use of a flying drone 1 equipped with a probe 27 configured to set a contact with a lighting receptor 11, a femtosecond laser 31 configured for creating a plasma towards the ground and a measuring unit 35 configured for measuring an electrical resistance in the loop created between the probe 27 and the ground enables checking the correct functioning of a lightning protection equipment.

## Claims

1. Flying drone (1) for checking lightning protection equipment (11, 23) comprising:
- a femtosecond laser (31),
- a probe (27),
- an electrical conductor (33) having a first end (33a) linked to the probe (27) and a second end (33b) arranged in the radiance of the femtosecond laser (31),
- a measuring unit (35) configured for measuring an electrical resistance along the electrical conductor (33),
- a processing unit (15),
wherein the processing unit (15) is configured:
- for controlling the flying drone (1) to set the probe (27) in contact with a lightning receptor (11) of a lightning protection equipment (11, 23),
- for controlling the femtosecond laser (31) to transmit a femtosecond pulse directed towards the ground while the probe (27) is in contact with the lightning receptor (11) and,
- for controlling the measuring unit (35) to measure an electrical resistance along the electrical conductor (33) during the transmission of the femtosecond pulse towards the ground.

2. Flying drone (1) in accordance with claim 1 wherein the processing unit (15) is also configured for comparing the measured electrical resistance with a predetermined value and for emitting an alarm if the measured value is higher than the predetermined value.

3. Flying drone (1) in accordance with one of the previous claims wherein the duration of the transmitted pulse of the femtosecond laser (31) is chosen so that the energy of the pulse produces an ionization of at least one gaseous species of the air and so that a plasma is formed between the flying drone (1) and the ground.

4. Flying drone (1) in accordance with the previous claim wherein the transmitted pulse of the femtosecond laser (31) has a duration comprised between ten and hundreds of femtoseconds.

5. Flying drone (1) in accordance with one of the previous claims wherein the wavelength of the femtosecond laser (31) is comprised between 800nm and 1300nm, preferably from 850nm to 1200nm.

6. Flying drone (1) in accordance with one of the previous claims wherein the probe (27) is located on a retractable arm (29) of the flying drone (1).

7. Flying drone (1) in accordance with one of the previous claims wherein the drone (1) comprises a positioning system (5, 5a, 5b, 13) to determine its position with respect to the lightning receptor (11), for example a positioning system based on a light detection and ranging "LIDAR" technology (5b) and/or an optical detector (13) such as a camera or video recorder.

8. Flying drone (1) in accordance with one of the previous claims wherein the flying drone (1) comprises a detector (13) configured for detecting an identification label associated with a lightning receptor (11) to locate and/or identify the lightning receptor (11).

9. Flying drone (1) in accordance with the previous claim wherein the identification label refers to a quick response "QR" code or a barcode and the detector (13) refers to a camera or video recorder.

10. Flying drone (1) in accordance with one of the claims 1 to 8 wherein the identification label refers to a radio frequency identification "RFID" label and the detector (13) refers to a RFID reader.

11. Method for checking a lightning protection equipment comprising the following steps:
- flying a drone (1), equipped with a probe (27) and a femtosecond laser (31), towards the lightning protection equipment, the probe (27) being electrically connected to the femtosecond laser (31) radiance by an electrical conductor (33), (101)
- setting the probe (27) in contact with a lightning receptor (11) of the lightning protection equipment, (103)
- transmitting, by the femtosecond laser (31), a femtosecond pulse directed towards the ground (104) while the probe (27) is in contact with the lightning receptor (11) and,
- measuring an electrical resistance of the electrical conductor (33) during the transmission of the femtosecond pulse (105).

12. Method in accordance with the previous claim wherein it also comprises the following steps:
- comparing the measured electrical resistance with a predetermined value (106) and,
- transmitting an alarm if the measured value is higher than the predetermined value.
